# EUROPEAN PATENT SPECIFICATION

(11) **EP 1 893 704 B1**
(45) Date of publication and mention of the grant of the patent: **31.03.2010**
(21) Application number: 06726825.0
(22) Date of filing: 20.04.2006
(51) Int. Cl.: C09D 11/00, C08G 63/08

(54) **AN INK JET INK**
TINTENSTRAHLTINTE
ENCRE POUR IMPRESSION JET D'ENCRE

(30) Priority: 22.04.2005 EP 05252523
(43) Date of publication of application: 05.03.2008
(73) Proprietor: Sun Chemical B.V., 1382 LV Weesp (NL)
(72) Inventor: CAIGER, Nigel Anthony, Wookey Hole, Somerset BA5 1BE (GB); GRANT, Alexander, Bath BA3 4RT (GB); SELMAN, Hartley David, Bristol BS31 2BU (GB); WILSON, Stephen Paul, Shepton Mallet, Somerset BA4 5JG (GB)
(74) Representative: Fletcher, Matthew James Edwin
(86) International application number: PCT/GB2006/001433
(87) International publication number: WO 2006/111746

(56) References cited:
- US-A1- 2004 244 641

## Description

The present invention relates to new printing ink compositions, and in particular to ink jet ink compositions that are cationically cured.

Cationic inks are preferred over free-radical cured inks for some applications due to good adhesion, low shrinkage, low odour and because curing is not inhibited by the presence of oxygen. However, it has proved difficult to formulate cationically cured inks that have the relatively low viscosity levels that are desirable for use in a wide range of ink jet applications. Furthermore, as only a relatively limited range of monomers are readily available that are suitable for use in cationically cured inks, the flexibility in the formulation of such inks is restricted.

Cationically curable inks are ink formulations that include a cationic initiator and least one cationically polymerisable component and are curable on exposure to curing radiation. Cationically curable inks may also comprise a free-radical initiator and a free-radical polymerisable component (such inks sometimes being referred to as hybrid inks).

Epoxide monomers undergo cationic ring-opening polymerisation and are widely used in printing inks. Cycloaliphatic epoxides have been found to react sufficiently rapidly for use in jet inks. However the high viscosity of cycloaliphatic epoxides means that jet ink compositions including cycloaliphatic epoxides as a polymerisable species must typically be "cut" with other compounds that act as diluents to reduce the viscosity of the composition. The term "epoxide monomer" used herein encompasses both monomer and oligomer species which are commonly used in the areas of ink jet printing and coatings.

It is known that including vinyl ether and oxetane monomers and oligomers in cationically cured ink compositions helps to achieve low viscosities. The use of vinyl ethers has the disadvantage that the cure speed can be significantly slowed and can cause post-cure odours. Vinyl ethers can also suffer from poor viscosity stability at elevated temperatures, such as the temperatures used in Piezo drop-on-demand (DOD) print heads.

Monofunctional oxetanes have the disadvantage that they are only suitable for use at low levels as the level of cure usually deteriorates when they are used at higher levels. Difunctional oxetanes have also been used but at the levels required to reduce the viscosity sufficiently for the ink to be used for ink jet printing, film shrinkage, poor adhesion and brittle films can occur. The approach of using of vinyl ether and oxetane compounds in ink compositions has also been shown to lead to poor adhesion on swellable plastic substrates because those materials do not attack or etch into the plastic.

JP 2004-323610A discloses ink jet inks comprising particular sulphonium photoinitiators and either propylene carbonate or a cyclic ester. The cyclic esters are stated to improve the compatibility of those particular suphonium initiators with the photopolymerizable components of the ink. However, JP 2004-323610A does not disclose or suggest the use of cyclic esters with non-sulphonium initiators.

US 2004/0244641 A1 discloses in tables 6 and 8 ink compositions comprising epoxide monomers and sulphonium initiators together with γ-butyrolactone.

JP 2004-10625A discloses in Example 5 an ink jet ink comprising a sulphonium initiator an epoxide compound and a lactone. The weight ratio of epoxide to lactone is 3:7. JP 2004-10625A does not disclose or suggest ink jet inks comprising γ-butyrolactone (gamma-butyrolactone).

Some sulphonium initiators have been found to generate benzene in the cured ink, and are therefore undesireable.

There remains a need to provide cationically curable inks having viscosities suitable for use as an ink jet ink also displaying good cure properties and, preferably, having good health and safety profiles, having a low odour levels, having good adherence to plastic substrates, producing flexible films on curing and comprising relatively inexpensive and readily available monomers and/or oligomers.

It has been found that, if used in sufficient quantities, the inclusion of γ-butyrolactone in ink jet inks also comprising epoxide monomers can provide a solution to the above-mentioned problems. It has moreover been found that particularly effective curing is achieved when the ratio of the epoxide to the γ-butyrolactone is within a certain range. This finding is surprising as it was widely believed that cyclic esters would be unreactive species in cationically curable inks and would therefore have a detrimental effect on the curing of an ink and, in particular, that they would inhibit cure speeds and create tacky films if used in high levels.

Thus, according to a first aspect of the invention, there is provided an energy-curable ink jet ink comprising one or more epoxide monomers, γ-butyrolactone and a cationic photoinitiator which is not a sulphonium initiator, in which the weight ratio of the one or more epoxide monomers to the γ-butyrolactone is in the range of from 15:1 to 2.5:1.
Such inks have been found to exhibit a good level of cure and have sufficiently low viscosities to be employed in ink jet printing. It has been found that γ-butyrolactone is particularly effective at reducing the viscosity of the ink, even when compared to structurally similar compounds such as ε-caprolactone. The inks typically have excellent health and safety profiles, and are low in odour. The inks according to the first aspect of the invention are curable by exposure to curing energy such as UV radiation.

The inventors have found that the weight ratio of the epoxide monomer to the γ-butyrolactone is of crucial importance in determining the level of cure obtained. More particularly, the inventors have found that at epoxide monomer: γ-butyrolactone weight ratio in the range of from 15:1 to 2.5:1 acceptable to excellent curing levels can be obtained under conditions which are representative of those used widely in the printing industry, whereas at ratios outside that range the curing tends to be inadequate, with the result that the films produced are weak. Preferably, the weight ratio of epoxide monomer to γ-butyrolactone is no more than 10:1, more preferably no more than 9:1. Preferably, the weight ratio of epoxide monomer to γ-butyrolactone is at least 3:1, more preferably at least 3.5:1, yet more preferably at least 4:1.

Advantageously, the inks comprise 3% or more, preferably 5% or more, optionally 10% or more and in some cases 12% or more by weight of γ-butyrolactone. It has been found that levels of γ-butyrolactone in ink jet ink compositions of 3% and above are not as detrimental to the cure of the inks as previously generally supposed and that when present in an amount of 5% or more, for example, 10% or more by weight of the ink, that the viscosity of the ink composition is lowered considerably. Advantageously, the inks comprise no more than 20%, preferably less than 15% by weight γ-butyrolactone. Levels of γ-butyrolactone from 5 to 20% and especially 5 to 15% by weight of the ink are preferred. Advantageously, the viscosity of the ink is less than 100 cPs at 25 °C, preferably less than 50 cPs at 25 °C and more preferably is less than 35 cPs at 25 °C. Advantageously, the ink composition has a viscosity of no less than 5 cPs at 25 °C, preferably no less than 7 cPs at 25 °C and more preferably no less than 10 cPs at 25 °C.

Many ink jet printers utilize heated print heads in order to reduce the viscosity of the ink at the point of jetting. Accordingly, the viscosity of the ink at an elevated temperature is also of interest. The inks of the invention have been found to have particularly low viscosities at such temperatures. Preferably, the ink has a viscosity of 50 °C of no more than 20 Centipoise (cPs), more preferably no more than 18 cPs, especially preferably no more than 15 cPs and in some cases no more than 13 cPs. In many cases the viscosity of the ink at 50 °C will be not less than 5 cPs.

Advantageously, the ink comprises at least 20%, preferably at least 30%, more preferably at least 40% and in some cases at least 50% by weight of the epoxide monomer. Optionally, the ink comprises no more than 80%, for example no more than 70% by weight of the epoxide monomer. The ink can comprise only a single epoxide monomer or mixtures of more than one epoxide monomer and references to "epoxide" and "epoxide monomer" as used herein should be understood to include mixtures of two to more epoxide monomers unless another meaning is clear from the context. Where more than one epoxide monomer is present, the ratio of epoxide monomer to γ-butyrolactone is based on the total weight of the expoxide monomers.

Cycloaliphatic epoxides (such as those sold under the designations Cyracure UVR6105, UVR6107, UVR6110 and UVR6128, by Dow), are particularly preferred because they tend to cure relatively quickly compared to linear epoxides. Other epoxides which may be used include such epoxy-functional oligomers/monomers as the glycidyl ethers of polyols [bisphenol A, alkyl diols or poly (alkylene oxides), which are di-, tri-, tetra- or hexa- functional]. Also, epoxides derived by the epoxidation of unsaturated materials may also be used (e.g. epoxidised soybean oil, epoxidised polybutadiene or epoxidised alkenes). Naturally occurring epoxides may also be used, including the crop oil collected from Vernonia galamensis.

The epoxides, especially cycloaliphatic epoxides, are one polymerisable species which are used in the compositions of the present invention. However, if desired, one or more other polymerisable species may also be included, for example an oxetane, which may be a mono-functional or multi-functional oxetane. These compounds are capable of polymerizing by a cationically induced ring-opening reaction. Advantageously, the ink further comprises a polymerisable oxetane species. It has been found that inks according to the present invention can be formulated with mono-functional and multi-functional oxetane monomers and oligomers to give inks with suitable viscosities and curing properties. Advantageously, the inks comprise no more than 60% by weight, more advantageously no more than 50% by weight and preferably no more than 30% by weight oxetane. It has been found that the ink jet ink compositions according to the first aspect of the invention can be formulated with relatively low levels of oxetanes and may include from 10 to 25% by weight oxetanes. Examples of suitable mono-functional oxetanes include 3-ethyl-3-hydroxymethyl-oxetane or 3-ethyl-3-[2-ethylhexyloxy)methyl]oxetane. A variety of multi-functional oxetane compounds is available for use in the compositions of the present invention. Preferred oxetanes are 3-ethyl-3-hydroxymethyl-oxetane, bis[(1-ethyl-3-oxetanyl)methyl] ether, 3-ethyl-3-[2-ethylhexyloxy)methyl]oxetane or [1,4-bis(3-ethyl-3-oxetanylmethoxy)methyl]benzene and especially trimethylolpropane oxetane. Another class of multi-functional oxetanes for use in the compositions of the present invention are linear polymers and copolymers having a plurality of oxetane groups, preferably an oxetane derivative of an epoxy novolac resin, for example the multifunctional oxetane sold as PNOX, available from Taogosei Co. Ltd.

As well as cycloaliphatic epoxides and optionally oxetanes, other reactive monomers/oligomers which may be used include the vinyl ethers of polyols, such as triethylene glycol divinyl ether, 1, 4-cyclohexane dimethanol divinyl ether and the vinyl ethers of poly(alkylene oxides). Advantageously, the ink jet inks of the invention comprises vinyl ethers in levels of less than 25% and preferably less than 10% by weight of the ink. Preferred formulations of the invention are substantially free of vinyl ethers. Reducing the levels of vinyl ethers or even eliminating the need for vinyl ethers altogether has been found to increase the cure speeds of the ink j et inks according to the invention enabling quicker cure speeds to be achieved at low levels of curing radiation (cure doses of less than 1000 mJ/cm²). Examples of vinyl ether functional prepolymers include the urethane-based products supplied by Allied Signal. Similarly, monomers/oligomers containing propenyl ether groups may be used in place of the corresponding compounds referred to above containing vinyl ether groups.

Other reactive species can be included in the ink composition, for example, styrene derivatives.

It has been found that the use of significant quantities of γ-butyrolactone enables the levels of many traditionally used diluents including oxetanes and vinyl ethers in the composition to be reduced which can lead to increased cure speeds.

The composition of the present invention also contains at least one cationic photoinitiator which is not a sulphonium salt and the ink is preferably substantially free of sulphonium photoinitiators, for example, comprising less than 2%, more preferably less than 1% by weight of sulphonium photoinitiator. Especially advantageously, no sulphonium initiator is present. Examples of such sulphonium salts include the mixture of compounds available under the trade name UVI6992 from Dow Chemical. Otherwise there is no particular restriction on the particular cationic photoinititor used, although iodonium salts are not preferred and in one embodiment the ink comprises less than 2%, preferably less than 1% by weight of iodonium photoinitiator. Advantageously, no iodonium initiator is present. Thianthrenium salts (such as Esacure 1187 available from Lamberti), are suitable photoinitiators. Particularly preferred cationic photoinitiators are the thioxanthonium salts, such as those described in WO 03/072567 A1, W 03/072568 A1 and WO 2004/0550000 A1, the disclosures of which are incorporated herein by reference. Because of the highly efficient curing behaviour of the inks of the invention, high levels of photoinitiator are usually not required. Advantageously, the inks comprise less than 5% by weight, preferably less than 4% by weight of photoinitiator.

The ink jet ink may further comprise a free radical photoinitiator and at least one free radically curable component.

It is also common to include polyols in ultraviolet cationically curable formulations, which promote the cross-linking by a chain-transfer process. Examples of polyols include the ethoxylated/propoxylated derivatives of, for example, trimethylolpropane, pentaerythritol, di-trimethylolpropane, di-pentaerythritol and sorbitan esters, as well as more conventional poly(ethylene oxide)s and poly(propylene oxide)s. Other polyols well known to those skilled in the art are the polycaprolactone diols, triols and tetraols, such as those supplied by Dow.

Additives which may be used in conjunction with the principal components of the ink formulations of the present invention include stabilizers, plasticizers, pigments, waxes, slip aids, leveling aids, adhesion promoters, surfactants and fillers. The compositions of the present invention typically comprises, as additional components to those referred to above, one or more of pigments, dyes, waxes, stabilizers, and flow aids, for example as described in "The Printing Ink Manual", 5th Edition, edited by R.H. Leach et al., published in 1993 by Blueprint.

In one embodiment the ink is substantially free of volatile solvents, that is, components which are not cured into the ink film and which evaporate away and are lost to the atmosphere. Preferably, the ink comprises less than 5%, more preferably less than 2% by weight of such volatile solvents. Such inks are particularly suitable for drop-on-demand printers. In another embodiment the ink is suitable for a continuous ink jet printer. Such inks typically contain a volatile solvent and a soluble salt to confer electrical conductivity on the ink.

The compositions of the present invention show significant advantages over the prior art since to attain ink jet viscosities with cationically curable inks has previously required either high levels of vinyl ether, which results in slow cure, poor film strength and odour, or high levels of bis[(1-ethyl-3-oxetanyl)methyl] ether, which results in high formulation cost, and brittle films. Both of these approaches also suffered from poor adhesion on some plastics since there was no attack of the ink in to the substrate (e.g. vinyl polymers).

According to a second aspect of the invention there is provided a process of printing which comprises the steps of applying an ink according to the first aspect of the invention to a substrate and exposing the ink to a curing radiation. The curing radiation may be UV radiation. It has been found that inks according to the invention can be used in printing processes where they are applied to a wide range of substrates including plastic substrates such as rigid PVCs (poly vinyl chlorides) or other vinyl substrates. The ink compositions according to the invention have in many cases been found to cure relatively quickly on exposure to relatively modest levels of curing radiation and so are suitable for a variety of ink jet printing applications. Advantageously, the compositions can be cured in processes in which the cure dose is less than 1000 mJ/cm². In practice, it is preferred that the cure dose used in the printing process according to the second aspect of the invention is less than 500 mJ/cm² and is preferably less than 300 mJ/cm². In some cases, printing inks according to the invention have been found to cure satisfactorily in processes in which cure doses of approximately 100 mJ/cm² are employed. Such cure doses are a significant improvement when compared to, for example, inks including significant quantities of vinyl ethers in which a cure dose of approximately 1000 mJ/cm² may be necessary.

The compositions of the present invention show benefits when used in various ink jet printing applications, including in line addressing/coding and card decoration (which benefits from fast cure and superior adhesion); in wide format graphics (lower cure doses required means light weight lower power UV sources can be used); and in single pass printing at high speed (there is no need for nitrogen blanketing as used with acrylate based free-radical curing formulations).

In a third aspect of the invention, there is provided a printed product comprising the cured ink as described in the first aspect of the invention. Advantageously, printed products can be produced on a wide range of plastic substrates, the inks of the invention have been found to displaying satisfactory curing properties on such substrates and good adhesion due to attack and etching by the inks. In particular, inks according to the invention have been found to adhere relatively well to rigid PVC substrates so enabling printed products to be prepared using cationically curable ink jet inks. Moreover in the examples below, printed products of the invention were found to have better flexibility than products printed using inks including higher quantities of oxetane diluents.

% by weight are based on the total weight of the ink, unless another meaning is obvious from the context.

The invention is further illustrated by way of the following examples. Those examples are not intended to limit the scope of the invention in any way.

### Examples 1 to 9

Ink compositions were prepared and tested as shown in table 1.

**Table 1**

| **Component** | **Example Compositions of the Invention** | | **Comparative Examples** | | | | | | |
|---|---|---|---|---|---|---|---|---|---|
| | **1** | **2** | **3** | **4** | **5** | **6** | **7** | **8** | **9** |
| γ-butyrolactone | 15 | 20 | 25 | 0 | 0 | 0 | 0 | 0 | 0 |
| ε-caprolactone | 0 | 0 | 0 | 15 | 20 | 25 | 0 | 0 | 0 |
| DVE-3 vinyl ether | 0 | 0 | 0 | 0 | 0 | 0 | 0 | 40 | 23 |
| DiTMPO | 21.4 | 16.4 | 11.4 | 21.4 | 16.4 | 11.4 | 51.4 | 1.4 | 26.4 |
| Cyr 6105 | 58.9 | 58.9 | 58.9 | 58.9 | 58.9 | 58.9 | 43.9 | 53.9 | 45.9 |
| Cyan Pigment CI 15:3 | 2.1 | 2.1 | 2.1 | 2.1 | 2.1 | 2.1 | 2.1 | 2.1 | 2.1 |
| Megaface F-479 | 0.1 | 0.1 | 0.1 | 0.1 | 0.1 | 0.1 | 0.1 | 0.1 | 0.1 |
| Omnicat 550 | 2.5 | 2.5 | 2.5 | 2.5 | 2.5 | 2.5 | 2.5 | 2.5 | 2.5 |
| Total: | 100 | 100 | 100 | 100 | 100 | 100 | 100 | 100 | 100 |
| Epoxide: lactone ratio | 3.9:1 | 2.9:1 | 2.3:1 | 3.9:1 | 2.9:1 | 2.3:1 | - | - | - |
| Viscosity @ 50C (cPs) | 14.2 | 12.1 | 10.7 | 21.2 | 19.6 | 18.8 | 16.4 | 8.8 | 9.9 |
| Cure Dose mJ/cm² | 100 | 100 | 100 | 100 | 100 | 100 | 100 | 1000 | 300 |
| MEK Double Rubs after 30 s | 25 | 25 | 10 | 5 | 2 | 1 | 50 | 45 | 12 |
| MEK Double Rubs after 1 hour | 200+ | 135 | 70 | 100 | 87 | 41 | 180 | 45 | 45 |
| Adhesion onto rigid PVC after 1 hour | 5B | 5B | 5B | 5B | 5B | 5B | 5B | 5B | 5B |
| Odour (5 = strong odour, 0 = no odour) | 0 | 0 | 1 | 1 | 1 | 1 | 0 | 5 | 4 |
| Cracking on flexible vinyl - 24 micron thickness | No Crack | No Crack | No Crack | No Crack | No Crack | No Crack | Crack | No Crack | No Crack |

| | | | | | | | | | |
|---|---|---|---|---|---|---|---|---|---|
| Notes to table 1. The viscosity was measured using Brookfield DVII+ viscometer, Spindle 18, at 100 rpm. The cure dose was that required from a medium pressure mercury lamp (undoped) in order to get touch dry coating after 10 seconds. Adhesion was measured using cross hatch tape test, on a Pentawhite rigid PVC substrate with a reading of 5B indicating there was no removal (0B being at least 65% removal). The odour rating was measure at 1 hour after curing. The cracking test involved coating and curing a 24 micron thick layer of ink on an Avery self adhesive display vinyl and bending the print through 180 degrees. DVE-3 is triethyleneglycol divinyl ether. TMPO is trimethylolpropane oxetane. Cyr 6105 is Cyracure UVR6105, an cycloaliphatic expoxide sold by DOW (having the chemical name 3,4-epoxycyclohxylmethyl-3,4-epoxycylohexane carboxylate). Cyan pigment CI 15:3 is a copper-containing phthalocyanine pigment supplied by BASF. Megaface F-479 is an organofluro surfactant supplied by Diauippon Ink and Chemicals, Inc. Omnicat 550 (10-biphenyl-4-yl-2-isopropyl-9-oxo-9H-thioxanthen-10-ium hexaflurophosphate) is a cationic photoinitiator supplied IGM. "MEK Double Rubs" is a well known rub resistance test for the level of cure of an ink with higher scores indicating a higher level of cure. Examples 3 to 9 in table 1 represent ink compositions that are outside the scope of the invention and are provided for comparative purposes only. Example compositions 1 and 2 are illustrative of compositions according to the first aspect of the invention. The last five rows of table 1 relate to the properties of printed products produced from printing the example compositions onto a substrate. The results in table 1 show that γ-butyrolactone is far more effective than ε-caprolactone in reducing ink viscosity and is almost as effective as DVE-3 vinyl ether. The MEK rub test is a measure of the extent of curing achieved and the results in Table 1 show that excellent curing is achieved when the epoxide:monomer ratio is within a particular range. That level of curing is better than is achieved with corresponding inks having DVE-3 or ε-caprolactone rather than the γ-butyrolactone. Comparative Example 3 shows that at an epoxide to γ-butyrolactone ratio of 2.3:1, the curing performance drops back again. | | | | | | | | | |

### Examples 10 to 14

Cyan ink formulations suitable for inkjet printing were prepared based on;

| | |
|---|---|
| 2.5% | Omnicat 550 photoinitiator |
| 2.1 % | Cyan pigment CI 15.3 |
| 0.1% | Megaface F479 Fluoro surfactant |
| 45.5% | UVR6105 cycloaliphatic epoxide |
| 29.8 - 49.8% | OXT-221 di-oxetane monomer ex Toagosei |
| 0-20% | γ-butyrolactone |

The viscosity and cure response were tested and the results are shown in table 2.

**Table 2**

| Example | % Butyrolactone | Weight ratio UVR6105: Butyrolactone | Viscosity@ 50°C cPs | MEK double rubs | |
|---|---|---|---|---|---|
| | | | | T= 30 seconds | T= 15 minutes |
| 10 (comp) | 0 | - | 14.9 | 6 | 37 |
| 11 | 5 | 9.1:1 | 14.1 | 156 | >200 |
| 12 | 10 | 4.6:1 | 12.9 | >200 | >200 |
| 13 | 15 | 3.0:1 | 11.7 | 79 | 147 |
| 14 (comp) | 20 | 2.3:1 | 10.9 | 46 | 58 |

The results in table 2 show again that the γ-butyrolactone reduces the ink viscosity and, within a certain range of epoxide: γ-butyrolactone ratios, markedly increases the efficiency of curing.

## Claims

1. An energy curable ink jet ink comprising one or more epoxide monomers, γ-butyrolactone and a cationic photoinitiator which is not a sulphonium initiator, in which the weight ratio of the one or more epoxide monomers to the γ-butyrolactone is in the range of from 15:1 to 2.5:1.

2. An ink jet ink according to claim 1, wherein the weight ratio of the one or more epoxide monomers to the γ-butyrolactone is in the range of from 10:1 to 2.5:1.

3. An ink jet ink according to claim 1 or claim 2, wherein the weight ratio of the one or more epoxide monomers to the γ-butyrolactone is in the range of from 9:1 to 3:1.

4. An ink jet ink according to any of claims 1 to 3, wherein the cationic photoinitiator is not an iodonium photoinitiator.

5. An ink jet ink according to any preceding claim, comprising at least 3% by weight γ-butyrolactone.

6. An ink jet ink according to claim 5, comprising at least 5% by weight cyclic ester.

7. An ink jet ink according to any preceding claim, comprising no more than 20% by weight γ-butyrolactone.

8. An ink jet ink according to claim 7, comprising no more than 15% by weight γ-butyrolactone.

9. An ink jet ink according to any preceding claim, wherein the viscosity of the ink is less than 100 cPs at 25 °C.

10. An ink jet ink according to any preceding claim, wherein the viscosity of the ink is less than 20 cPs at 50°C.

11. An ink jet ink according to claim 10 in which the viscosity of the ink is 15 cPs or less at 50 °C.

12. An inkjet ink according to any preceding claim, further comprising a polymerisable oxetane species.

13. An inkjet ink according to claim 12, comprising no more than 50% by weight oxetane.

14. An ink jet ink according to any preceding claim, comprising from 20% to 80% by weight epoxide monomer.

15. An ink jet ink according to any preceding claim, further comprising a free radical photoinitiator and at least one free-radical polymerisable monomer.

16. A process of printing which comprises the steps of applying an ink according to any one of the preceding claims to a substrate and exposing the ink to a curing radiation sufficient to cure the ink.

17. A process of printing according to claim 16, wherein the curing radiation is UV radiation.

18. A printed product including a layer of the cured product of an ink as claimed in any one of claims 1 to 15 or as produced by a process as claimed in claim 16 or claim 17.

## Patentansprüche

1. Eine durch Energie härtbare Tintenstrahltinte, umfassend ein oder mehrere Epoxidmonomere, γ-Butyrolacton und einen kationischen Photoinitiator, welcher kein Sulphoniuminitiator ist, wobei das Gewichtsverhältnis der ein oder mehreren Epoxidmonomere zum γ-Butyrolacton im Bereich von 15:1 bis 2,5:1 liegt.

2. Eine Tintenstrahltinte gemäß Anspruch 1, wobei das Gewichtsverhältnis der ein oder mehreren Epoxidmonomere zum γ-Butyrolacton im Bereich von 10:1 bis 2,5:1 liegt.

3. Eine Tintenstrahltinte gemäß Anspruch 1 oder Anspruch 2, wobei das Gewichtsverhältnis der ein oder mehreren Epoxidmonomere zum γ-Butyrolacton im Bereich von 9:1 bis 3:1 liegt.

4. Eine Tintenstrahltinte gemäß einem der Ansprüche 1 bis 3, wobei der kationische Photoinitiator kein Iodiumphotoinitiator ist.

5. Eine Tintenstrahltinte gemäß einem der vorstehenden Ansprüche, umfassend mindestens 3 Gew.-% γ-Butyrolacton.

6. Eine Tintenstrahltinte gemäß Anspruch 5, umfassend mindestens 5 Gew.-% an cyclischem Ester.

7. Eine Tintenstrahltinte gemäß einem der vorstehenden Ansprüche, umfassend nicht mehr als 20 Gew.-% γ-Butyrolacton.

8. Eine Tintenstrahltinte gemäß Anspruch 7, umfassend nicht mehr als 15 Gew.-% γ-Butyrolacton.

9. Eine Tintenstrahltinte gemäß einem der vorstehenden Ansprüche, wobei die Viskosität der Tinte weniger als 100 cPs bei 25°C beträgt.

10. Eine Tintenstrahltinte gemäß einem der vorstehenden Ansprüche, wobei die Viskosität der Tinte weniger als 20 cPs bei 50°C beträgt.

11. Eine Tintenstrahltinte gemäß Anspruch 10, wobei die Viskosität der Tinte 15 cPs oder weniger bei 50°C beträgt.

12. Eine Tintenstrahltinte gemäß einem der vorstehenden Ansprüche, ferner umfassend eine polymerisierbare Oxetanspezies.

13. Eine Tintenstrahltinte gemäß Anspruch 12, umfassend nicht mehr als 50 Gew.-% Oxetan.

14. Eine Tintenstrahltinte gemäß einem der vorstehenden Ansprüche, umfassend 20 bis 80 Gew.-% an Epoxidmonomer.

15. Eine Tintenstrahltinte gemäß einem der vorstehenden Ansprüche, ferner umfassend einen radikalischen Photoinitiator und mindestens ein radikalisch polymerisierbares Monomer.

16. Ein Druckverfahren, welches die Schritte des Auftragens einer Tinte gemäß einem der vorstehenden Ansprüche auf ein Substrat und des Aussetzens der Tinte einer Härtungsstrahlung, die ausreicht, die Tinte zu härten, umfasst.

17. Ein Druckverfahren gemäß Anspruch 16, wobei die Härtungsstrahlung UV-Strahlung ist.

18. Ein gedrucktes Produkt umfassend eine Schicht des gehärteten Produkts einer wie in einem der Ansprüche 1 bis 15 beanspruchten Tinte oder wie durch ein Verfahren wie in Anspruch 16 oder Anspruch 17 beansprucht hergestellt.

## Revendications

1. Encre pour impression à jet d'encre durcissable par l'action d'une énergie, comprenant un ou plusieurs monomères d'époxyde, une γ-butyrolactone et un photoinitiateur cationique qui n'est pas un initiateur de sulfonium, dans laquelle le rapport pondéral du ou des monomères d'époxyde à la γ-butyrolactone se situe dans la plage de 15:1 à 2,5:1.

2. Encre pour impression à jet d'encre selon la revendication 1, dans laquelle le rapport pondéral du ou des monomères d'époxyde à la γ-butyrolactone se situe dans la plage de 10:1 à 2,5:1.

3. Encre pour impression à jet d'encre selon la revendication 1 ou la revendication 2, dans laquelle le rapport pondéral du ou des monomères d'époxyde à la γ-butyrolactone se situe dans la plage de 9:1 à 3:1.

4. Encre pour impression à jet d'encre selon l'une quelconque des revendications 1 à 3, dans lequel le photoinitiateur cationique n'est pas un photoinitiateur d'iodonium.

5. Encre pour impression à jet d'encre selon l'une quelconque des revendications précédentes, comprenant au moins 3 % en poids de γ-butyrolactone.

6. Encre pour impression à jet d'encre selon la revendication 5, comprenant au moins 5 % en poids d'ester cyclique.

7. Encre pour impression à jet d'encre selon l'une quelconque des revendications précédentes, ne comprenant pas plus de 20 % en poids de γ-butyrolactone.

8. Encre pour impression à jet d'encre selon la revendication 7, ne comprenant pas plus de 15 % en poids de γ-butyrolactone.

9. Encre pour impression à jet d'encre selon l'une quelconque des revendications précédentes, dans laquelle la viscosité de l'encre est inférieure à 100 cPs à 25 °C.

10. Encre pour impression à jet d'encre selon l'une quelconque des revendications précédentes, dans laquelle la viscosité de l'encre est inférieure à 20 cPs à 50 °C.

11. Encre pour impression à jet d'encre selon la revendication 10 dans laquelle la viscosité de l'encre est de 15 cPs ou moins à 50 °C.

12. Encre pour impression à jet d'encre selon l'une quelconque des revendications précédentes, comprenant en outre une espèce d'oxétane polymérisable.

13. Encre pour impression à jet d'encre selon la revendication 12, ne comprenant pas plus de 50 % en poids d'oxétane.

14. Encre pour impression à jet d'encre selon l'une quelconque des revendications précédentes, comprenant 20 % à 80 % en poids de monomère d'époxyde.

15. Encre pour impression à jet d'encre selon l'une quelconque des revendications précédentes, comprenant en outre un photoinitiateur de radicaux libres et au moins un monomère de radicaux libres polymérisable.

16. Procédé d'impression qui comprend les étapes consistant à appliquer une encre selon l'une quelconque des revendications précédentes sur un substrat et à exposer l'encre à un rayonnement durcissant suffisant pour durcir l'encre.

17. Procédé d'impression selon la revendication 16, dans lequel le rayonnement durcissant est un rayonnement UV.

18. Produit imprimé comprenant une couche du produit durci d'une encre selon l'une quelconque des revendications 1 à 15 ou comme élaboré par un procédé selon la revendication 16 ou la revendication 17.
